# EUROPÄISCHE PATENTANMELDUNG

(11) **EP 1 336 971 A1**
(43) Veröffentlichungstag der Anmeldung: **20.08.2003**
(21) Anmeldenummer: 03002747.8
(22) Anmeldetag: 06.02.2003
(51) Int. Cl.: G11C 7/10

(54) **Speichermodul**

(30) Priorität: 06.02.2002 DE 10204874
(71) Anmelder: SIEMENS AKTIENGESELLSCHAFT, 80333 München (DE)
(72) Erfinder: Epp, Wolfgang, 76744 Wörth (DE); Klamm, Arnold, 76870 Kandel (DE); Michalk, Detlev, 76189 Karlsruhe (DE); Schönemann, Konrad, 75056 Sulzfeld/Baden (DE)

(57) **Zusammenfassung**

Die Erfindung betrifft ein Speichermodul, das wenigstens ein Speicherelement (2, 3) und einen Direktstecker (4) auf einer Karte (1) umfasst und das durch ein Rechnerprotokoll synchron mit einfacher Datenrate beschrieben und ausgelesen wird.

Um den Bedarf an kostengünstigen Speichermodulen zu decken, die in der Anwendung wie ein synchrones DRAM-Modul einfacher Datenrate betrieben werden, bei denen jedoch nicht mehr auf synchrone Speicherelemente einfacher Datenrate zurückgegriffen werden muss, ist das wenigstens eine Speicherelement (2, 3) des Speichermoduls erfindungsgemäß ein synchrones Speicherelement doppelter Datenrate (DDR) und ist ein Logikschaltkreis (5) zwischen dem wenigstens einen synchronen Speicherelement (2, 3) und dem Direktstecker (4) des Moduls angeordnet, der eine Übersetzung des Rechnerprotokolls in ein Speicherprotokoll und umgekehrt durchführt.

## Beschreibung

Die Erfindung betrifft Speichermodule nach dem Oberbegriff von Anspruch 1.

Die Entwicklung der dynamischen Schreib-/Lese-Speicher (DRAM) schreitet sehr schnell voran. Vor einiger Zeit wurden Speichermodule entwickelt, die auf der Verwendung von asynchronen DRAMs basieren, nämlich "extended data out"- (EDO-) bzw. "fast page mode"- (FPM-) DRAMs. Diese DRAM-Speicherelemente haben eine Zugriffszeit von 60 bis 70 ns. Höhere Datenraten als die asynchronen DRAM-Speicherelemente bieten Speicherelemente auf Basis synchroner DRAMs (SDRAM). Daher wurde seither die Produktion der asynchronen DRAMs immer weiter zugunsten der synchronen DRAMs reduziert. Die neueste Generation von Speichern sehen so genannte DDR (double data rate)-Speicher vor, welche in Zukunft vermehrt eingesetzt werden.

In vielen Bereichen werden jedoch nach wie vor auf synchronen SDRAMs basierende Speichermodule einfacher Datenrate eingesetzt. Für die Anwender dieser Module wird es in Zukunft zunehmend schwieriger, geeignete synchrone Speicherelemente einfacher Datenrate zu bekommen.

Es wird dann der Bedarf an kostengünstigen Speichermodulen entstehen, die in der Anwendung wie ein synchrones DRAM-Modul einfacher Datenrate betrieben werden, bei denen jedoch nicht mehr auf SDRAM-Speicherelemente zurückgegriffen werden muss.

Diese Aufgabe wird erfindungsgemäß durch ein Speichermodul gemäß Anspruch 1 gelöst. Bevorzugte Ausführungsformen der Erfindung sind Gegenstand der Unteransprüche.

Erfindungsgemäß werden zur Realisierung von synchronen Speichermodulen einfacher Datenrate (SDR) synchrone Speicherelemente doppelter Datenrate (DDR) verwendet. Die Ansteuerung von SDRAMs und DDR-DRAMs unterscheidet sich aber in einigen wesentlichen Punkten. Die Erfindung löst dieses Problem, indem zwischen den auf dem Modul bestückten DDR-RAMs und dem Direktstecker des Moduls ein kundenspezifischer Schaltkreis (konfigurierbarer Logikschaltkreis) geschaltet wird, der eine Übersetzung der verschiedenen Protokolle durchführt. Dadurch wird erreicht, dass sich das Modul auf der Busseite wie ein SDRAM einfacher Datenrate verhält, aber intern die Ansteuerung für DDR-RAMs vorhanden ist.

Das erfindungsgemäße Speichermodul, das wenigstens ein Speicherelement und einen Direktstecker auf einer Karte umfasst und das durch ein Rechnerprotokoll synchron mit einfacher Datenrate beschrieben und ausgelesen wird, ist dadurch gekennzeichnet, dass das wenigstens eine Speicherelement des Speichermoduls ein Speicherelement doppelter Datenrate ist und dass ein Logikschaltkreis zwischen dem wenigstens einen synchronen Speicherelement und dem Direktstecker des Moduls angeordnet ist, der eine Übersetzung des Rechnerprotokolls in ein Speicherprotokoll und umgekehrt durchführt.

Vorzugsweise ist der Logikschaltkreis ein programmierbares Bauelement (PLD), das anwendungsabhängig konfiguriert ist (ASIC).

Ein Vorteil der Erfindung besteht darin, dass ein Modul mit sehr wenigen Komponenten günstig verfügbar sein wird, da die zukünftig erhältlichen DDR-DRAMs im Vergleich zu den älteren SDRAMs eine hohe Kapazität haben werden; denn nur noch die Ersteren werden weiterentwickelt. Der Preis für synchrone DDR-DRAMs wird im Verlauf der Zeit sehr niedrig werden, wogegen der Preis für SDRAMs einfacher Datenrate, bedingt durch die zunehmend geringe verfügbare Stückzahl, immer höher werden wird. Durch die erfindungsgemäße Verwendung von DDR-Speicherelementen mit geringen Bauteilkosten wird es damit möglich werden, die Kosten dann hochpreisiger Module zu senken.

Das erfindungsgemäße Speichermodul unterscheidet sich optisch von einem Speichermodul nach dem Stand der Technik dadurch, dass zusätzliche Logikschaltkreise vorgesehen sein müssen.

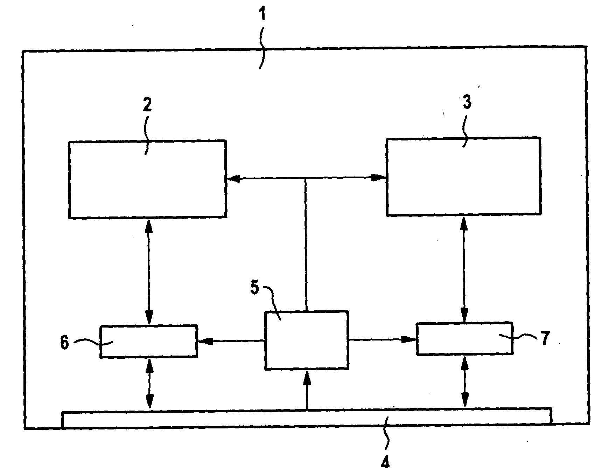

Weitere Merkmale und Vorteile der Erfindung ergeben sich aus der folgenden Beschreibung eines bevorzugten Ausführungsbeispiels, bei der Bezug genommen wird auf die beigefügte Zeichnung.

Die Figur zeigt ein Blockschaltbild eines Speichermoduls gemäß der Erfindung.

Das Speichermodul in der Figur umfasst zwei Speicherelemente 2 und 3 auf einer Karte 1. Die Karte 1 ist über einen Direktstecker 4 mit z. B. einem (nicht dargestellten) Motherboard verbunden.

In dem Speichermodul werden temporär Daten abgelegt, d. h., sie müssen im Verlauf von Arbeitsschritten bei der Durchführung von Programmen nach dem Start des Rechners von einem (nicht dargestellten) Zentralprozessor in den Speicher geschrieben werden. Bei Bedarf werden sie von dem Zentralprozessor wieder ausgelesen usw. Beim Ausschalten des Rechners, d. h. bei Unterbrechung der Stromversorgung des Speichermoduls, gehen die darin abgespeicherten Daten verloren. Darüber hinaus müssen die Daten auch bei eingeschalteter Stromversorgung in regelmäßigen Intervallen aufgefrischt werden. Die Kommunikation zwischen dem Zentralprozessor und dem Speichermodul ist durch ein Rechnerprotokoll geregelt.

Bei Speichermodulen, die synchron mit einfacher Datenrate beschrieben und ausgelesen werden, wird es, wie oben erläutert, ein Problem werden, preiswerte Speicherelemente zu finden. Erfindungsgemäß werden daher als Speicherelemente 2 und 3 des Speichermoduls synchrone Speicherelemente doppelter Datenrate (DDR) eingesetzt. Da das Protokoll, mit dem das Auslesen und Beschreiben der Speichermodule durch den Zentralprozessor geregelt wird, von der Art der Speicherelemente 2 und 3 des Speichermoduls abhängt, wird erfindungsgemäß ein Logikschaltkreis 5 am Eingang des Speichermoduls vorgesehen, d. h. unmittelbar hinter dem Direktstecker 4 des Moduls. Dieser Logikschaltkreis 5 zwischen dem synchronen Speicherelement 2 bzw. 3 und dem Direktstecker 4 sorgt für eine Übersetzung des Rechnerprotokolls in ein Speicherprotokoll und umgekehrt. Das Speicherprotokoll dient dazu, die Speicherelemente anzusprechen; das Rechnerprotokoll dient zur Kommunikation zwischen Zentralprozessor und Speichermodul. Dadurch wird erreicht, dass sich für den Anwender das Speichermodul mit DDR-Speicherelementen nach außen wie ein SDR-Speichermodul einfacher Datenrate verhält.

Zwischen den Speicherelementen 2 bzw. 3 und dem Direktstecker 4 der Modulkarte 1 sind ein erstes Pufferregister 6 bzw. zweites Pufferregister 7 geschaltet, die von dem Logikschaltkreis 5 angesteuert werden. Über diese Register 6 und 7 erfolgt das Lesen und Schreiben in den Speicherelementen 2 und 3, während die Adressierung der Speicherbereiche in den Speicherelementen 2 und 3 über den Logikschaltkreis 5 selbst erfolgt. Der Datenaustausch ist in der Figur durch Doppelpfeile angedeutet, die Adressierung erfolgt über die Verbindungen, die durch einen einfachen Pfeil dargestellt sind.

Das Speichermodul unterscheidet sich daher optisch von einem Speichermodul nach dem Stand der Technik dadurch, dass zusätzliche Logikschaltkreise vorgesehen sein müssen.

Vorzugsweise handelt es sich bei dem Logikschaltkreis 5 um einen anwendungsspezifischen Schaltkreis (ASIC), der als programmierbarer Logikbaustein (programmable logic device) aufgebaut ist.

## Patentansprüche

1. Speichermodul, das wenigstens ein Speicherelement (2, 3) und einen Direktstecker (4) auf einer Karte (1) umfasst und das durch ein Rechnerprotokoll synchron mit einfacher Datenrate beschrieben und ausgelesen wird,
**dadurch gekennzeichnet,**
**dass** das wenigstens eine Speicherelement (2, 3) des Speichermoduls ein synchrones Speicherelement doppelter Datenrate ist und
**dass** ein Logikschaltkreis (5) zwischen dem wenigstens einen synchronen Speicherelement (2, 3) und dem Direktstecker (4) des Moduls angeordnet ist, der eine Übersetzung des Rechnerprotokolls in ein Speicherprotokoll und umgekehrt durchführt.

2. Speichermodul nach Anspruch 1,
**dadurch gekennzeichnet,**
**dass** der Logikschaltkreis (5) ein programmierbares Bauelement (PLD) ist, das anwendungsabhängig konfiguriert ist (ASIC).
